# EUROPEAN PATENT SPECIFICATION

(11) **EP 0 267 772 B1**
(45) Date of publication and mention of the grant of the patent: **13.01.1993**
(21) Application number: 87309904.8
(22) Date of filing: 09.11.1987
(51) Int. Cl.: H01L 23/467, H01L 23/367

(54) **Heat exchanger and method of making same**
Wärmeaustauscher und Verfahren zum Herstellen desselben
Echangeur de chaleur et son procédé de fabrication

(30) Priority: 10.11.1986 GB 8626826; 02.09.1987 US 92255
(43) Date of publication of application: 18.05.1988
(73) Proprietor: Microelectronics and Computer Technology Corporation, Austin Texas 78759 (US)
(72) Inventor: Herrell, Dennis, J., Austin Texas 78730 (US); Gupta, Omkarnath Ramnath, Englewood Colorado 80111 (US); Hilbert, Claude, Austin Texas 78717 (US)
(74) Representative: Lucas, Brian Ronald

(56) References cited:
- EP-A-02 531 216
- IBM TECHNICAL DISCLOSURE BULLETIN, vol. 28, no. 7, December 1985, pages 3058-3059, New York, US; "High performance air-cooled module"
- IBM TECHNICAL DISCLOSURE BULLETIN, vol. 29, no. 2, July 1986, pages 768-769, New York, US; "Circuit device with cooling by air directed toward fin-supporting surface with fin height configured to maintain air velocity as air spreads over surface"

## Description

This invention relates to a heat exchanger and to a method of making the same. While useful in various applications, heat exchangers in accordance with the present invention are particularly useful for cooling electronic components.

IBM Technical Disclosure Bulletin Vol. 28 No. 7, December 1985, pages 3058-3059 discloses a heat exchanger for cooling or heating an object, which heat exchanger comprises a plurality of spaced apart, substantially parallel, thermally conductive fins. In use, cooling air is blown towards the object (a chip) and exits parallel thereto.

EP-A-0 253 126, which is relevant under Article 54(3) EPC discloses a heat exchanger in which a plurality of pin fins are mounted on a pyramidal base. In use, cooling air is blown towards the base and is diverted outwardly by the sides of the pyramid which face away from one another.

According to the present invention there is provided a heat exchanger for cooling or heating an object, which heat exchanger comprises a plurality of spaced apart substantially parallel thermally conductive fins, characterized in that first and second inclined diverting means are provided which face one another so that when a gas is introduced in one direction into said heat exchanger said first diverting means diverts part of said gas in a second direction generally perpendicular to said one direction, and said second diverting means diverts part of said gas in a third direction generally perpendicular to said one direction and opposite said second direction.

In one embodiment of the invention, the fins are of generally triangular shape and are arranged so that alternate fins face in opposite directions and the longest side of the fins comprise said diverting means.

Advantageously, said fins are of generally right-angled triangular shape. Alternatively, the longest side of said fins is curved.

Preferably, a tip of at least some of said fins is folded back on to itself.

In another embodiment of the invention, the diverting means comprises a generally triangular spacer member disposed between adjacent fins.

Preferably, the fins are of generally rectangular shape.

If desired, the longest side of said generally triangular spacer member may be curved.

Advantageously, said fins and said diverting means are integrally formed.

In a further embodiment of the invention the fins are of generally parallelogram shape.

Heat exchangers in accordance with the present invention preferably include respective end plates disposed at two opposite ends thereof.

The present invention also provides an electronic assembly comprising a plurality of components, characterized in that at least some of said components have heat exchangers in accordance with the invention mounted thereon, and wherein ducting is arranged to direct, in use, cooling gas into said heat exchangers.

There is also provided a method of making an embodiment of a heat exchanger in accordance with the invention, which method comprises the steps of cutting a length of thermally conductive material to form a strip of interconnected fins of generally triangular shape, and folding said strip where said fins are interconnected.

Advantageously, said fins are right-angled triangles.

Preferably, said method includes the step of folding at least some of the free tips of said fins back upon said fins.

The present invention also provides a method of making another embodiment of a heat exchanger in accordance with the invention, which method comprises the steps of forming a generally parallelogram shaped piece of thermally conductive material and folding said material to form a 'V' shape member defining two fins.

For a better understanding of the present invention reference will now be made, by way of example, to the accompanying drawings, in which:-
Fig. 1 is a view, partly in elevation and partly in cross-section, of one embodiment of a heat exchanger in accordance with the present invention in use;
Fig. 2 is a view taken along line 2-2 of Fig. 1;
Fig. 3 is an enlarged perspective view, with part cut away, of the heat exchanger and chip shown in Figs. 1 and 2;
Fig. 4 is a view, partly in elevation and partly in cross-section, of a second embodiment of a heat exchanger in accordance with the present invention in use;
Figs. 5 and 6 are schematic views illustrating steps in the manufacture of the heat exchanger shown in Fig. 4;
Fig. 7 is a perspective view of the heat exchanger shown in Fig. 4 with its end plates removed for clarity;
Fig. 8 is a perspective view of a third embodiment of the heat exchanger in accordance with the present invention;
Fig. 9 is a cross-section illustrating a step in the manufacture of the heat exchanger shown in Fig. 8;
Fig. 10 is a top plan view illustrating a step in the manufacture of a fourth embodiment of a heat exchanger in accordance with the present invention;
Fig. 11 is a cross-sectional view taken along line 11-11 of Fig. 10;
Fig. 12 is an elevational view of a fifth embodiment of a heat exchanger in accordance with the present invention;
Fig. 13 is a view taken along line 13-13 of Fig. 12;
Fig. 14 is a view, partly in elevation and partly in cross-section, of a seventh embodiment of a heat exchanger in accordance with the invention in use;
Fig. 15 is a view taken along line 15-15 of Fig. 14;
Fig. 16 is an elevational view of a plurality of heat exchangers as shown in Figs. 14 and 15 arranged in a cooling array; and
Fig. 17 is a view taken along line 17-17 of Fig. 16.

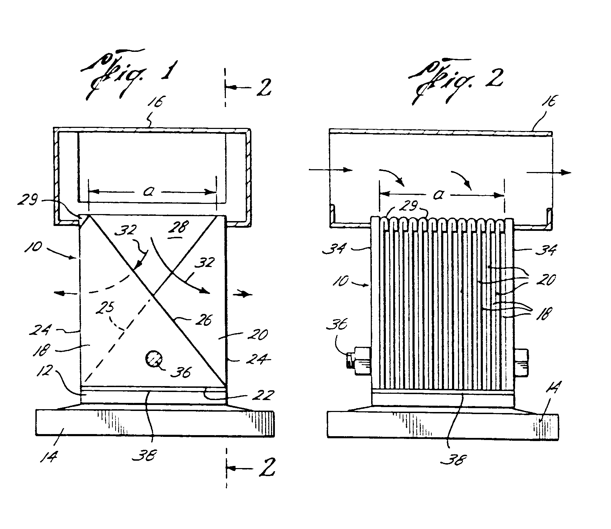

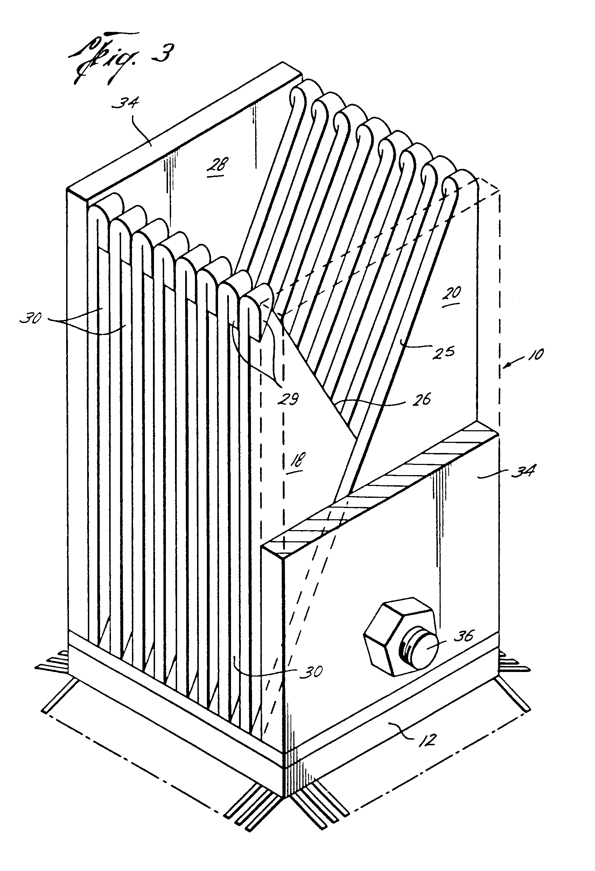

Referring now to the drawings, and particularly to Figs. 1, 2 and 3, reference numeral 10 generally indicates a heat exchanger which is attached to integrated circuit chip 12 which in turn is mounted on a substrate 14. The heat exchanger 10 receives a cooling gas such as air from a duct 16 which is arranged to conduct the cooling gas to one of more heat exchangers 10 although the flow of cooling gas through the heat exchanger 10 may be reversed if desired.

The heat exchanger 10 comprises a plurality of thin, flat, substantially parallel, thermally conductive cooling fins 18 and 20. The cooling fins 18 and 20 may be of any suitable thermal conductive materials such as copper, aluminium, beryllium oxide or aluminum oxide. Aluminum is presently preferred in view of its low density. Preferably the cooling fins 18 and 20 are identical for ease of manufacture. Each of the cooling fins 18 and 20 includes a bottom 22, a first side 24, a second side 26 and a tip 29.

In the embodiment of Figs. 1 to 3, the cooling fins 18 and 20 are in the shape of right-angle triangles and have an aspect ratio greater than 1:0, i.e., the first side 24 is longer than the bottom 22. As an alternative the second side 26 may be curved or circular, i.e., similar to the shapes shown in Figs. 11, 12, 15 and 16.

Alternate cooling fins 18, 20 are reversed so as to face in opposite directions to provide a multiplicity of gas passageways 30 between adjacent fins 18 and between adjacent fins 20.

In use, cooling gas enters the heat exchanger 10 downwardly through inlet 28. The cooling gas is then diverted by the second side 26 of the cooling fans 18, 20 and leaves the heat exchanger 10 substantially horizontally through gas passageways 30.

The tips 29 of each of the cooling fins 18 and 20 are folded over or alternately dipped in, for example epoxy, to maintain the cooling fins in spaced juxtaposition and to form an edge.

For example, each of the cooling fins 18 and 20 may be 0.127 mm (5 mils) thick and the heat exchanger 10 may comprise eighty fins for a 10.16 mm x 10.16 mm (400 x 400 mil) area heat exchanger with a height of 17.78 mm (700 mils). However, the thickness and exact dimensions of the heat exchanger 10 can be varied in order to optimize the heat exchange and to minimize the air flow resistance. It will be noted that the embodiment being described has a modular feature of increasing the number of fins as the size of the base increases. This feature allows the heat exchanger to be sized proportionally to the surface to be cooled which is also approximately proportional to the amount of the heat to be dissipated in many applications.

In order to duct the cooling gas through the heat exchanger 10, an end plate 34 is provided at each end of the plurality of cooling fins 18 and 20 and is connected to the duct 16 for directing the cooling gas through the gas passageways 30.

The end plates 34 and cooling fins 18 and 20 may be secured together with any suitable securing means such as a bolt 36. Alternatively, the assembly can be soldered together.

A thermal conductive base 38 is connected to the bottom 22 of the cooling fins 18 and 20 and the bottom surface thereof may be attached to the chip 12 by any suitable means, for example, the bottom surface may be machined to an accurate finish and soldered to the chip 12. Alternatives include the use of microcapillary attachment through the use of microcapillaries provided on the underside of the thermally conductive base 38 or the back of the chip 12. Alternatively, the heat exchanger 10 can be pressed against the back of the chip 12 for simple pressure contact and thermal conducting greases can also be used. In short, all methods of attachment ensuring low thermal impedance can be used. Conventional systems use a compliant or conformable interface in multi-chip applications where the surfaces of the chips do not form a planar surface (a common problem). The preferred embodiments do not require a compliant interface since the heat exchanger 10 may be directly mounted on the chip 12.

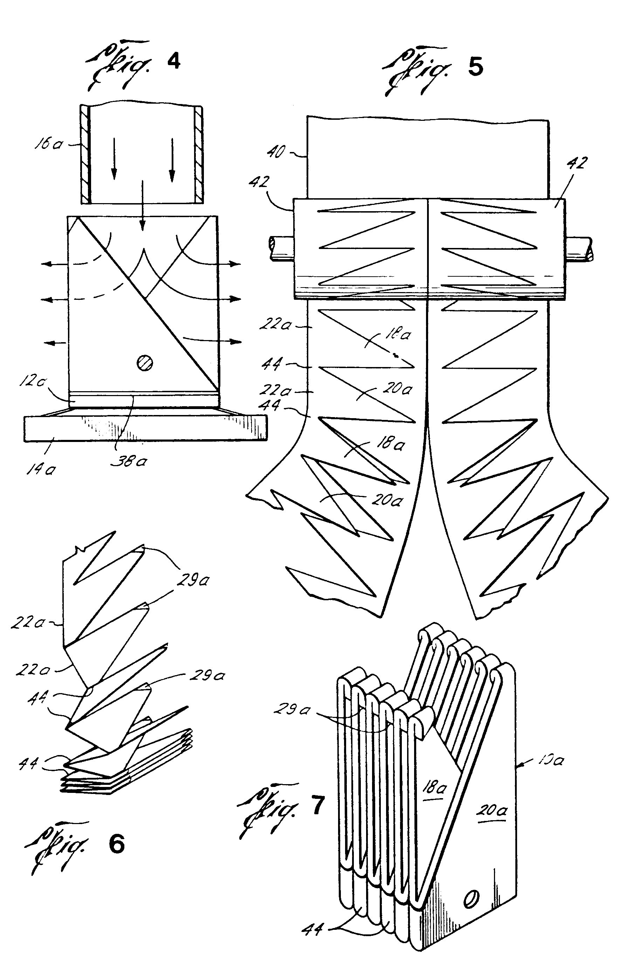

The structure thusfar described provides several considerable advantages. First, the cooling air flowing through the gas passageways 30 produces a lower pressure drop than conventional systems and hence the gas moving system required can be less powerful. Secondly, the average velocity of the air through the gas passageways 30 is reduced. This reduces restrictions to flow at both the inlet and the outlet of the passageways 30 and hence the acoustic noise generated. The structure shown in Figs. 1 and 3 has provided adequate cooling for components running at 30 W with only a gas pressure of 747 Pa (3 inches of water) required at an air flow rate of about 57 litres per minute. A thermal resistance of 1.7^{o} centigrade per watt was achieved for a heat sink base of 0.66 square centimetres consisting of 46 fins each 0.178 mm (7 mils) wide and spaced 0.178 mm (7 mils) apart with a height of 1.2 cm. This performance is equivalent to about 1.2^{o} centigrade temperature rise per watt of power dissipated per square centimetre, a remarkable achievement for such a simple, low cost air cooled heat exchanger.

Calculations indicate that the heat exchanger will provide excellent performance as an air cooler. At an operating pressure of 2490 Pa (10 inches of water) and an air flow of about 2.83 l/s (6 cfm) the heat exchanger 10 itself offers a thermal resistance of less than 0.6 K/W. This corresponds to a temperature rise of only 30 K for a 50 W chip, which would then add to the intrinsic temperature rise of about 10 K to yield a 40 K temperature rise of the heat producing junctions on a chip over ambient. For the same area the efficiency of a triangular cooling fin such as 18 and 20 is greater than that of a standard rectangular fin. For narrow gas passageways 30, the air viscosity reduces the flow rate drastically and increases caloric resistance; for wider gas passageways 30 the reduced fin surface area as well as the increased boundary layer thickness increases the convective heat transfer resistance. Calculations indicate that the optimum fin thickness may be 0.254 mm (10 mils) and in such cases with an applied air pressure of 249 Pa (1 inch of water) the total thermal resistance of the heat exchanger is predicted to be 1.5 K/W with an air flow rate of 0.94 l/s (2.0 cfm).

Other and further embodiments and modifications may be provided and their method of manufacture which will be described hereinafter where like parts corresponding to those in Figs. 1 to 3 are similarly numbered with the addition of the suffix "a", "b", "c" , "e" and "f" respectively.

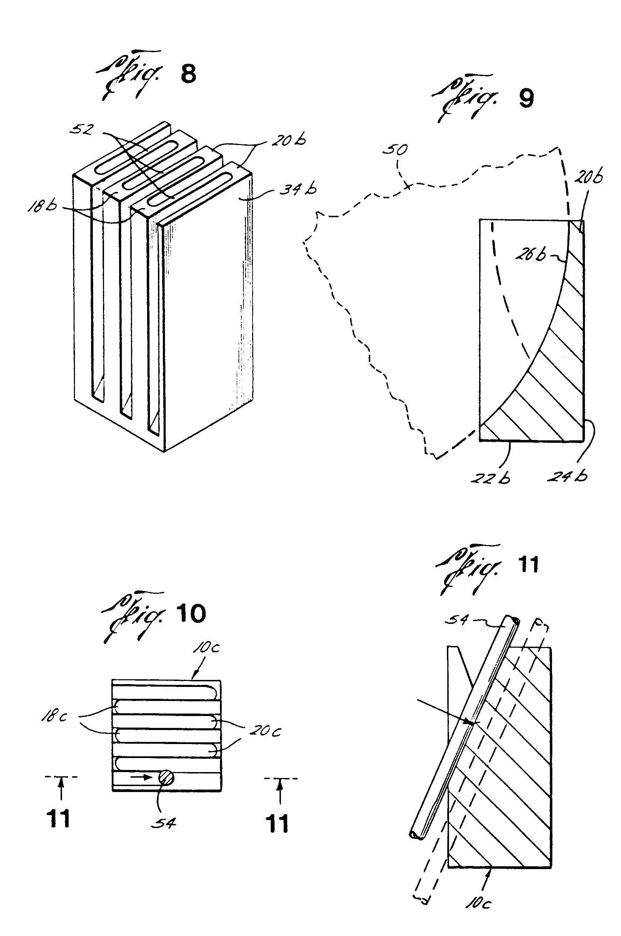

Referring now to Figs. 4, 5, 6 and 7, a modified version of the heat exchanger and a method of manufacturing the same are shown.

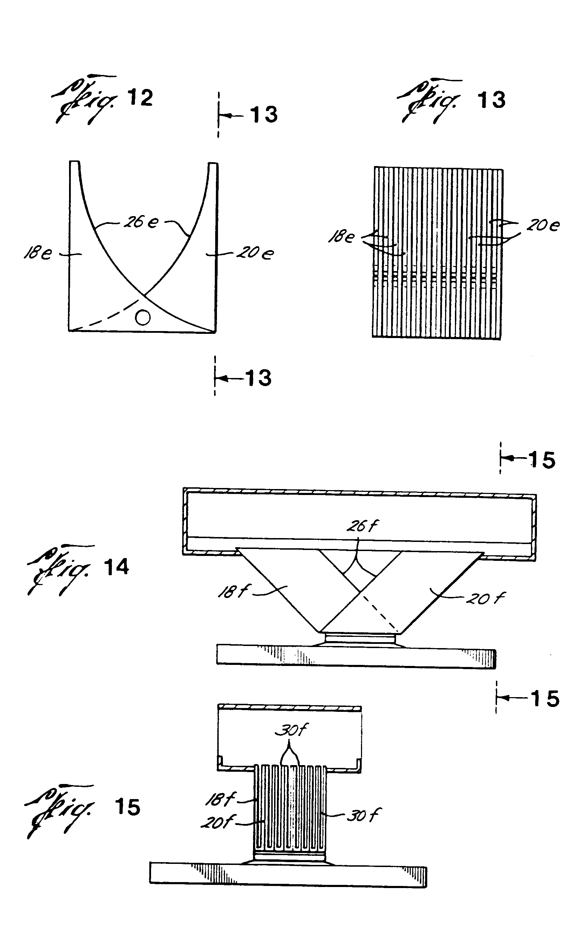

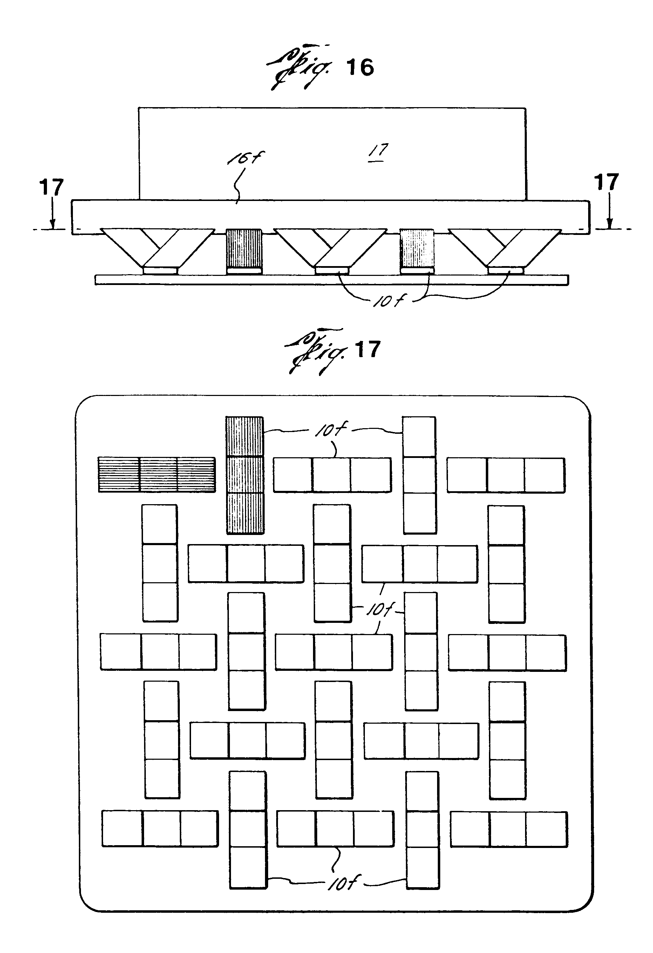

Referring first to Fig. 5, a sheet of thermal conductive material 40, such as copper is provided, in which one or more cutters 42 cut the sheet into a plurality of right-angled triangle shaped cooling fins 18a and 20a with the adjacent fins 18a and 20a being connected adjacent their bottoms 22a by a connection 44. Thereafter, as best seen in Fig. 6, the tips 29a are folded over and back towards the bottoms 22a and the adjacent fins 18a and 20a are folded along the connections 44 towards each other in a direction whereby adjacent fins 18a and 20a are reversed relative to one another to form a heat exchanger 10a as shown in Fig. 7 which then may be suitably connected to a chip 12a and receives a cooling gas from a duct 16a and function similarly to that described in connection with Figs. 1 to 3.

Referring now to Figs. 8 and 9, another embodiment of a heat exchanger in accordance with the present invention is shown as heat exchanger 10b which is made out of an integral piece of thermally conductive material in which fins 18b and 20b are formed therein by utilizing a circular saw blade 50 to create oppositely directed fins having a circular side 26b to provide oppositely directed air outlet passageways. In this case, because of the method of manufacture, the fins are generally rectangular.

Referring now to Figs. 10 and 11, another embodiment 10c of a heat exchanger is shown in which the cooling fins 18c and 20c are manufactured out of a solid piece of material by the use of a heating element 54 which by movement in a series of parallel alternating paths at opposite sides of the heat exchanger 10c creates an integral heat exchanger 10c having similar characteristics to those of Figs. 4 to 8 by providing right-angled triangular shapes facing in reversing directions and interconnected at their edges.

The heat exchangers described can be made in a variety of materials. It may be desirable to match the thermal expansion of the chip and the heat exchanger with a suitable material, such as silicon or molybdenum.

Referring now to Figs. 12 and 13 a modification is provided in which the cooling fins 18e and 20e are substituted in Figs. 1 to 3 for cooling fins 18 and 20. This embodiment is a minor variation of Figs. 1 to 3 in that the only difference is that the sides 26e are now curved and in this case made circular, This structure provided for a somewhat smoother gas flow transition from the inlet to the outlet direction and hence provides a still lower pressure drop and less turbulence and noise. This particular embodiment also uses somewhat less materials which reduces cost and weight and has less fin overlap at the bottom of the heat exchanger. Such a structure will reduce the conduction resistance through the bottom part a little and thus should provide a slightly better performance for a given size.

The foregoing embodiments provide very efficient, compact and low cost heat exchangers which enable the removal of more power than previously thought possible with air cooling. However, the noise generation and high pressure requirements for the air mover were undesirable in some applications.

Another embodiment of a heat exchanger in accordance with the present invention is shown in Figs. 14 and 15 in which the cooling fins 18f and 20f are parallelogram shaped. Each parallelogram includes a bottom, top and two sides which extend upwardly and outwardly from the bottom. For example, the sides may be inclined at approximately 45^{o} relative to the bottom. The heat exchanger 10f incorporates the excellent cooling performance of the earlier embodiments by utilizing a multitude of thin fins 18f and 20f. However, in order to lower the pressure requirements, the heat exchanger 10f is not as compact as the heat exchanger 10 of Figs. 1 to 3. The parallelogram shaped cooling fins 18f and 20f have a greater surface area than the fins 18 and 20 of Figs. 1 to 3, and the gas passageways are larger. For example, the gas passageways in the embodiment 10f are preferably twice as wide as the thickness of the fins. This additional gas passage area provided increased inlet and outlet cross-sectional areas for the air flow. This decreases the air velocity substantially and hence reduces the amount of noise generated. The cooling fins 18f and 20f may be formed by any suitable manufacturing method as previously described. One suitable method is cutting the desired thickness of thermal conductive material such as copper into double sized fins, that is, a fin which is twice the combined length of the fins 18f and 20f. The double size fin is then folded in the middle to form the two fins 18f and 20f with a space in between the cooling fins 18f and 20f. Suitable spacers may be provided to maintain the gas passageways. It will be appreciated that the ends of the heat exchanger 10f are provided with end plates similar to end plates 34.

While some of the compactness of the early embodiments has been traded off, the heat exchanger 10f will still allow approximately 25% substrate coverage by semi-conductor components. In one experimental test using a heat exchanger 10f having a 1.2 x 1.0 cm heat sink base with a height of 1.2 cm using 0.25 mm (10 mil) thick copper fins 18f and 20f spaced on alternate 0.254 mm (10 mil) and 0.508 mm (20 mil) centres, the thermal resistance of the arrangement was found to be 1.7^{o}C/W at an air flow of 0.94 l/s (2 cfm) and at a pressure of 62 Pa (0.25 inches of water). This is very low thermal resistance for such a small pressure and air flow rate and such results are highly unexpected in view of previous prior art results. Such an embodiment was operated with a simple, inexpensive low power (10 W) tube-axial fan manufactured by EG & G Rotron under the trademark "Muffin Fan". The noise generated by a single heat exchanger 10f was less than 50 dBA.

Traditionally, air cooling was fairly inefficient in making only partial use of the cooling potential of air by simply blowing the air around heat exchangers with an open fin structure. Consequently air carried by one heat exchanger was used to cool another. As best seen in Figs. 16 and 17, the heated exhaust air from any heat exchanger does not materially affect any other heat exchanger. The heat exchanger volume of the heat exchanger 10 of Figs. 1 to 3 is less than 1 cubic centimetre. Utilizing the heat exchanger 10 in an array. up to 33% substrate coverage by chips has been achieved without a performance degradation. On the other hand, the heat exchangers 10f of Figs. 14 and 15 offer a similar thermal performance but at a much reduced pressure requirement. The pressure requirements of the heat exchangers of 10f have been reduced by sacrificing compactness, thereby resulting in a somewhat bigger heat exchanger of about 3 cubic centimetre which limits the substrate coverage to about 25%.

The heat exchanger 10f has the same modular advantage as the heat exchanger 10 can be scaled to smaller or larger chip power heat dissipation by removing or adding fin pairs. Additionally, like the heat exchanger 10, the heat exchanger 10f may be connected to each chip without requiring a conventional compliant interface, which is a rather poorly conducting media, between the chips and the heat exchangers where the heat flux densities are highest.

The various embodiments described above generally employ the basic ideas of using a plurality of thin fins and narrow gas cooling passageways which extend between the top of the heat sink and laterally ends between both sides of the heat sink. The advantages of these structures lie in using the same structure to both duct the gas normally to the inlet direction while providing heat transfer at the same time. Each of the different embodiments has advantages of its own and different versions may be preferred for different applications.

## Claims

1. A heat exchanger for cooling or heating an object, which heat exchanger (10) comprises a plurality of spaced apart, substantially parallel, thermally conductive fins (18, 20), characterized in that first and second inclined diverting means (26, 26b, 26e, 26f) are provided which face one another so that when a gas is introduced in one direction into said heat exchanger (10) said first diverting means diverts part of said gas in a second direction generally perpendicular to said one direction, and said second diverting means diverts part of said gas in a third direction generally perpendicular to said one direction and opposite said second direction.

2. A heat exchanger as claimed in Claim 1, characterized in that said fins (18, 20; 18a, 20a; 18e, 20e) are of generally triangular shape and are arranged so that alternate fins face in opposite directions and the longest side of said fins comprise said diverting means.

3. A heat exchanger as claimed in Claim 2, characterized in that said fins are of generally right-angled triangular shape.

4. A heat exchanger as claimed in Claim 2 or 3, characterized in that the longest side of said fins (18e, 20e) is curved.

5. A heat exchanger as claimed in Claim 2, 3 or 4, characterized in that a tip (29) of at least some of said fins is folded back on to itself.

6. A heat exchanger as claimed in Claim 1, characterized in that said diverting means comprises a generally triangular spacer member (26b) disposed between adjacent fins.

7. A heat exchanger as claimed in Claim 6, characterized in that said fins (18b, 20b; 18c, 20c; 56) are of generally rectangular shape.

8. A heat exchanger as claimed in Claim 6, characterized in that the longest side of said generally triangular spacer member (26b) is curved.

9. A heat exchanger as claimed in Claim 6, 7 or 8, characterized in that said fins and said diverting means are integrally formed.

10. A heat exchanger as claimed in Claim 1, characterized in that said fins (18f, 20f) are of generally parallelogram shape.

11. A heat exchanger as claimed in any preceding Claim, characterized in that it includes respective end plates (34) disposed at two opposite ends thereof.

12. An electronic assembly comprising a plurality of components, characterized in that at least some of said components have heat exchangers as claimed in any preceding Claim mounted thereon, and wherein ducting (16f) is arranged to direct, in use, cooling gas into said heat exchangers.

13. A method of making a heat exchanger according to Claim 2, characterized in that said method comprises the steps of cutting a length of thermally conductive material to form a strip of interconnected fins of generally triangular shape, and folding said strip where said fins are interconnected.

14. A method according to Claim 13, characterized in that said fins are right-angled triangles.

15. A method according to Claim 13 or 14, including the step of folding at least some of the free tips of said fins back upon said fins.

16. A method of making a heat exchanger according to Claim 10, characterized in that said method comprises the steps of forming a generally parallelogram shaped piece of thermally conductive material and folding said material to form a 'V' shape member defining two fins.

## Patentansprüche

1. Wärmetauscher (10) zum Kühlen oder Beheizen eines Objektes, der mehrere mit Abstand zueinander angeordnete, im wesentlichen parallele wärmeleitende Bleche (18, 20) aufweist, dadurch gekennzeichnet, daß erste und zweite geneigte Ablenkelemente (26, 26b, 26e, 26f) vorgesehen sind, die einander gegenüberliegen, so daß, wenn ein Gas in einer Richtung in den Wärmetauscher (10) geführt wird, die ersten Ablenkelemente einen Teil des Gases in eine zweite Richtung ablenken, die im wesentlichen senkrecht zur ersten Richtung gerichtet ist und die zweiten Ablenkelemente einen Teil des Gases in eine dritte Richtung ablenken, die im wesentlichen senkrecht zur ersten Richtung gerichtet und der zweiten Richtung entgegengesetzt ist.

2. Wärmetauscher nach Anspruch 1, dadurch gekennzeichnet, daß die Bleche (18, 20; 18a, 20a; 18e, 20e) von annähernd dreieckiger Form und so angeordnet sind, daß sich die Bleche wechselweise in entgegengesetzte Richtungen abflachen und daß die längsten Seiten der Bleche die Ablenkelemente enthalten.

3. Wärmetauscher nach Anspruch 2, dadurch gekennzeichnet, daß die Bleche annähernd die Form eines rechtwinkligen Dreiecks haben.

4. Wärmetauscher nach Anspruch 2 oder 3, dadurch gekennzeichnet, daß die längsten Seiten der Bleche (18e, 20e) gekrümmt sind.

5. Wärmetauscher nach einem der Ansprüche 2, 3 oder 4, dadurch gekennzeichnet, daß die Spitzen (29) wenigstens einiger der Bleche bis zur Anlage der eigenen Seitenfläche umgebogen sind.

6. Wärmetauscher nach Anspruch 1, dadurch gekennzeichnet, daß die Ablenkelemente einen annähernd dreieckigen Abstandshalter (26b) umfassen, der zwischen zwei benachbarten Blechen angeordnet ist.

7. Wärmetauscher nach Anspruch 6, dadurch gekennzeichnet, daß die Bleche (18b, 20b; 18c, 20c; 56) eine annähernd rechtwinklige Form haben.

8. Wäremtauscher nach Anspruch 6, dadurch gekennzeichnet, daß die längste Seite des annähernd dreieckigen Abstandshalters (26b) gekrümmt sind.

9. Wärmetauscher nach einem der Ansprüche 6, 7 oder 8, dadurch gekennzeichnet, daß die Bleche und die Ablenkelemente einteilig ausgebildet sind.

10. Wärmetauscher nach Anspruch 1, dadurch gekennzeichnet, daß die Bleche (18f, 20f) im wesentlichen parallelogrammförmig sind.

11. Wärmetauscher nach einem der vorgehenden Ansprüche, dadurch gekennzeichnet, daß er Endplatten (34) aufweist, die an zwei entgegengesetzten Enden angeordnet sind.

12. Elektronikeinrichtung mit einer Mehrzahl von Komponenten, dadurch gekennzeichnet, daß wenigstens einige der Komponenten Wärmetauscher nach einem der vorhergehenden Ansprüche aufweisen, die auf diesen angeordnet sind, und wobei eine Führung (16f) angeordnet ist, um während des Betriebs Kühlgas in die Wärmetauscher zu leiten.

13. Verfahren zur Herstellung eines Wärmetauschers nach Anspruch 2, gekennzeichnet durch die Verfahrensschritte Schneiden eines Längenabschnitts eines thermisch leitenden Materials zur Bildung eines Streifens untereinander verbundener Bleche von annähernd dreieckiger Form und Falten des Streifens an den Stellen, an denen die Bleche untereinander verbunden sind.

14. Verfahren nach Anspruch 13, dadurch gekennzeichnet, daß die Bleche rechtwinklige Dreiecke bilden.

15. Verfahren nach Anspruch 13 oder 14, dadurch gekennzeichnet, daß wenigstens einige der freien Spitzen der Bleche bis zur Anlagen an den Blechen umgebogen sind.

16. Verfahren zum Herstellen eines Wäremtauschers nach Anspruch 10, gekennzeichnet durch die Verfahrensschritte Bildung eines annähernd parallelogrammförmigen Stückes eines thermisch leitenden Materials und Falten zu einem V-förmigen Teil, welches zwei Bleche bildet.

## Revendications

1. Echangeur de chaleur pour refroidir ou chauffer un objet, lequel échangeur de chaleur (10) comprend une pluralité d'ailettes séparées pratiquement parallèles thermiquement conductrices (18, 20) caractérisé en ce que des premier et second moyens de déviation inclinés (26, 26b, 26e, 26f) sont prévus, lesquels se font face l'un à l'autre, de sorte que lorsqu'un gaz est introduit dans un sens dans ledit échangeur de chaleur (10), ledit premier moyen de déviation dévie une partie dudit gaz dans un second sens généralement perpendiculaire audit premier sens, et en ce que ledit second moyen de déviation dévie une partie dudit gaz dans un troisième sens généralement perpendiculaire audit premier sens et opposé audit second sens.

2. Echangeur de chaleur selon la revendication 1, caractérisé en ce que lesdites ailettes (18, 20 ; 18a, 20a ; 18e, 20e) sont d'une forme généralement triangulaire et sont disposées de sorte que des ailettes alternées se font face dans les sens opposés et que le côté le plus long desdites ailettes comprend lesdits moyens de déviation.

3. Echangeur de chaleur selon la revendication 2, caractérisé en ce que lesdites ailettes sont d'une forme généralement en triangle-rectangle.

4. Echangeur de chaleur selon la revendication 2 ou 3, caractérisé en ce que le côté le plus long desdites ailettes (18e, 20e) est incurvé.

5. Echangeur de chaleur selon la revendication 2, 3 ou 4, caractérisé en ce qu'un bout (29) d'au moins certaines desdites ailettes est replié sur lui-même.

6. Echangeur de chaleur selon la revendication 1, caractérisé en ce que le moyen de déviation comprend un élément d'écartement généralement triangulaire (26b) disposé entre des ailettes adjacentes.

7. Echangeur de chaleur selon la revendication 6, caractérisé en ce que lesdites ailettes (18b, 20b ; 18c, 20c ; 56) sont de forme généralement rectangulaire.

8. Echangeur de chaleur selon la revendication 6, caractérisé en ce que le côté le plus long dudit élément d'écartement généralement triangulaire (26b) est incurvé.

9. Echangeur de chaleur selon la revendication 6, 7 ou 8, caractérisé en ce que lesdites ailettes et ledit moyen de déviation sont formés solidairement.

10. Echangeur de chaleur selon la revendication 1, caractérisé en ce que lesdites ailettes (18f, 20f) sont d'une forme généralement en parallélogramme.

11. Echangeur de chaleur selon l'une quelconque des revendications précédentes, caractérisé en ce qu'il comporte des plaques d'extrémité respectives (34) disposées à ses deux extrémités opposées.

12. Montage électronique comprenant une pluralité de composants, caractérisé en ce qu'au moins certains desdits composants ont des échangeurs de chaleur comme revendiqué dans l'une quelconque des revendications précédentes montés sur ceux-ci et dans lequel la canalisation (16f) est prévue pour diriger en utilisation le gaz de refroidissement dans lesdits échangeurs de chaleur.

13. Procédé pour fabriquer un échangeur de chaleur selon la revendication 2, caractérisé en ce que le procédé comprend les étapes consistant à découper une longueur de matériau thermiquement conducteur pour former une bande d'ailettes interconnectées de forme généralement triangulaire et replier ladite bande lorsque lesdites ailettes sont interconnectées.

14. Procédé selon la revendication 13, caractérisé en ce que lesdites ailettes sont des triangles-rectangles.

15. Procédé selon la revendication 13 ou 14, comprenant l'étape consistant, à replier au moins certains des bouts libres desdites ailettes sur lesdites ailettes.

16. Procédé pour fabriquer un échangeur de chaleur selon la revendication 10, caractérisé en ce que ledit procédé comprend les étapes consistant à former une pièce en forme généralement de parallélogramme d'un matériau thermiquement conducteur et replier ledit matériau pour former un élément en forme de "V" définissant deux ailettes.
